# EUROPÄISCHE PATENTANMELDUNG

(11) **EP 2 523 225 A1**
(43) Veröffentlichungstag der Anmeldung: **14.11.2012**
(21) Anmeldenummer: 11003779.3
(22) Anmeldetag: 09.05.2011
(51) Int. Cl.: H01L 31/05, H01L 31/052

(54) **Verfahren zum Betreiben einer Photovoltaikanlage und Photovoltaikanlage**

(71) Anmelder: Sens, Andreas, 21493 Schwarzenbek (DE)
(72) Erfinder: Sens, Andreas, 21493 Schwarzenbek (DE)
(74) Vertreter: Hauck Patent- und Rechtsanwälte

(57) **Zusammenfassung**

Bei einem effizienten Verfahren zum Betreiben einer Photovoltaikanlage mit mehreren Ketten aus jeweils mehreren zusammengeschalteten Photovoltaikmodulen und mindestens einem von den Ketten gespeisten Wechselrichter mit mehreren Nachführeinrichtungen werden
● die von einzelnen Photovoltaikmodulen gelieferten elektrischen Leistungen ermittelt,
● die Photovoltaikmodule entsprechend den von ihnen gelieferten Leistungen zu verschiedenen Ketten zusammengeschaltet werden, wobei jede Kette aus Photovoltaikmodulen besteht, die eine für die Kette spezifische Leistung liefern, und
● die von den verschiedenen Ketten gelieferten Gleichströme verschiedenen Nachführeinrichtungen zugeführt und über den mindestens einen Wechselrichter in einen Wechselstrom umgewandelt. Die Photovoltaikanlage kann von vornherein so konstruiert werden, dass sie zur Durchführung des Verfahrens geeignet ist. Alternativ ist eine entsprechende Nachrüstung bestehender Photovoltaikanlagen möglich.

## Beschreibung

Die Erfindung bezieht sich auf ein Verfahren zum Betreiben einer Photovoltaikanlage und auf eine Photovoltaikanlage mit mehreren Strings aus jeweils mehreren zusammengeschalteten Photovoltaikmodulen.

"Photovoltaik" bezeichnet die direkte Umwandlung von Sonnenenergie in elektrische Energie mit Hilfe von Solarzellen. Sonnenlicht besteht aus Lichtteilchen, den sog. "Photonen". Trifft ein Photon auf eine Solarzelle, stößt es dort freie Elektronen an, sodass diese in Bewegung geraten. Durch die Bewegung der Elektronen entsteht Elektrizität. Solarzellen liefern einen Gleichstrom, der direkt am Ort der Erzeugung genutzt oder durch Wechselrichter in einem Wechselstrom umgewandelt und ggfs. in das öffentliche Stromnetz eingespeist wird.

Photovoltaikanlagen bestehen grundsätzlich aus vier wesentlichen Komponenten:
Dem Montagesystem, der Verkabelung, den Photovoltaikmodulen (auch "Solarmodule" genannt) sowie dem Wechselrichter mit Nachführeinrichtung. Die drei ersten Komponenten werden gemeinsam auch als "Generator" oder "Solargenerator" bezeichnet. Die Nachführeinrichtung (auch "Tracker" genannt) ermittelt ständig den Arbeitspunkt, bei dem das Photovoltaikmodul seine maximale Leistung erbringt. Hierfür wird in Zeitabständen der Innenwiderstand des Wechselrichters minimal geändert, wodurch sich gleichzeitig sowohl der Spannungs- als auch der Stromwert des Photovoltaikmoduls ändert. Diese Veränderung beeinflusst die abgegebene Leistung des Photovoltaikmoduls. Wenn sich die Leistung erhöht, arbeitet der Wechselrichter bei den neuen Spannungs- und Stromwerten. Bei einer Verringerung der Leistung kehrt der Wechselrichter wieder zu den früheren Werten zurück. Beim Nachführen auf den Arbeitspunkt maximaler Leistung (auch "Maximum Power Point (MPP)-Tracking" genannt) wird angestrebt, dass das Solarmodul immer im Punkt der maximalen Leistungsabgabe betrieben wird.

Bei der Herstellung eines Solargenerators werden mehrere Solarmodule zu einer Kette zusammengeschaltet. Die Parallelschaltung mehrerer Solarmodule führt zu einer Erhöhung des gelieferten Stroms und die Reihenschaltung zu einer Erhöhung der bereitgestellten Spannung. Die Kette aus parallel und/oder in Reihe zusammengeschalteten Modulen bezeichnet man als "String". Je nach Auslegung der Solaranlage werden auch mehrere Strings zusammengeschaltet.

Der von den Strings gelieferte Gleichstrom gelangt über den Tracker in den Wechselrichter und wird dort in Wechselstrom umgewandet.

Bei Auslegung und Betrieb von Photovoltaikanlagen kommt es vielfach zu Problemen hinsichtlich der Verschattung. Die verschatteten Flächen der Photovoltaikmodule können entweder nicht zur Energiegewinnung genutzt werden oder es kommt zu Ertragsminderung. Wenn die lichtempfindlichen Flächen der Photovoltaikmodule mit Raureif überzogen oder mit Schnee zugedeckt sind, hat dies entsprechende Auswirkungen.

Wird ein Solarmodul teilweise oder ganz verschattet, hat es eine verminderte Leistung. Alle Verschattungen, außer den temporären, unterliegen dem Sonnenverlauf mit ständig wechselnden Verhältnissen. Der Schattenverlauf ändert sich über den ganzen Tag. Wird z.B. ein Generator von einem Gebäude, einem nahen Waldstück, einem Berg oder durch andere Solarmodule (z.B. durch aufgeständerte Solarmodule) verschattet, so arbeitet der Generator ganz oder teilweise, je nach Auslegung, Tages- und Jahreszeit, mit Verlusten. Temporäre Verschattungen können insbesondere auf vorübergehende Verunreinigungen durch Laub, Vogelkot oder Staub beruhen, die durch einen Regenschauer wieder beseitigt werden können.

Wenn ein String an einem Wechselrichter mit Tracker angeschlossen ist, wird der gesamte String im Punkt seiner maximalen Leistungsabgabe betrieben. Dabei arbeiten jedoch die einzelnen Solarmodule des Strings regelmäßig nicht an ihrem jeweiligen Punkt maximaler Leistung. Wenn einzelne Solarmodule verschattet oder beschädigt sind, kann dies die Gesamtleistung des Strings stark herabsetzen.

Die Leistung eines Strings kann somit stark dadurch beeinträchtigt werden, dass einzelne Solarmodule des Strings verschattet sind oder aufgrund anderer Einflüsse eine verhältnismäßig geringe oder gar keine Leistung liefern.

Davon ausgehend liegt der Erfindung die Aufgabe zugrunde, ein Verfahren zum Betreiben einer Photovoltaikanlage und eine Photovoltaikanlage zur Verfügung zu stellen, das bzw. die effizienter arbeitet.

Die Aufgabe wird durch ein Verfahren mit den Merkmalen von Anspruch 1 und durch eine Photovoltaikanlage mit den Merkmalen von Anspruch 7 gelöst. Vorteilhafte Ausgestaltungen des Verfahrens und der Photovoltaikanlage sind in Unteransprüchen angegeben.

Das erfindungsgemäße Verfahren zum Betreiben einer Photovoltaikanlage mit mehreren Ketten aus jeweils mehreren zusammengeschalteten Photovoltaikmodulen und mindestens einem von den Ketten gespeisten Wechselrichter mit mehreren Nachführeinrichtungen umfasst die folgenden Schritte:
● Die von einzelnen Photovoltaikmodulen gelieferten elektrischen Leistungen werden ermittelt,
● die Photovoltaikmodule werden entsprechend den von Ihnen gelieferten Leistungen zu verschiedenen Ketten zusammengeschaltet, wobei jede Kette aus Photovoltaikmodulen besteht, die eine für die Kette spezifische Leistung liefern, und
● die von den verschiedenen Ketten gelieferten Gleichströme werden verschiedenen Nachführeinrichtungen zugeführt und über den mindestens einen Wechselrichter in einen Wechselstrom umgewandelt.

Die erfindungsgemäße Photovoltaikanlage mit mehreren Ketten aus jeweils mehreren zusammengeschalteten Photovoltaikmodulen hat
● mehrere Photovoltaikmodule,
● Mittel zum Erfassen der von den einzelnen Photovoltaikmodulen gelieferten elektrischen Leistungen,
● mehrere Gleichspannungsnetze, von denen jedes für Photovoltaikmodule mit einer spezifischen Leistung vorgesehen ist, die jeweils mit jedem Photovoltaikmodul verbunden sind,
● mindestens einen Wechselrichter mit mehreren Nachführeinrichtungen, die jeweils mit einem Gleichspannungsnetz verbunden sind,
● elektrische Schaltvorrichtungen zwischen den Photovoltaikmodulen und den Gleichspannungsnetzen und
● mindestens eine mit den elektrischen Schaltvorrichtungen und den Mitteln zum Erfassen der gelieferten elektrischen Leistungen verbundene elektrische Steuerungsvorrichtung, die so beschaffen ist, dass sie die Photovoltaikmodule entsprechend den von Ihnen gelieferten Leistungen jeweils in das Gleichspannungsnetz hineinschaltet, das für Photovoltaikmodule mit derselben spezifischen Leistung vorgesehen ist.

Erfindungsgemäß werden die Photovoltaikmodule aufgrund der von ihnen jeweils gelieferten Leistungen verschiedenen Ketten bzw. Strings zugeordnet. Die spezifische Leistung, die für die Zuordnung eines Photovoltaikmoduls zu einem String maßgeblich ist, kann eine bestimmte elektrische Leistung sein. Bevorzugt ist sie ein bestimmter elektrischer Leistungsbereich. Im einfachsten Falle gibt es einen String für starker Sonneneinstrahlung ausgesetzte Photovoltaikmodule, die eine hohe elektrische Leistung liefern, und einen weiteren String für verschattete Photovoltaikmodule, die eine geringe elektrische Leistung liefern. Für die Zuordnung der Photovoltaikmodule zu den beiden Strings kann die Steuerungsvorrichtung einen Leistungsgrenzwert heranziehen, Photovoltaikmodule, die den Leistungsgrenzwert erreichen, in den String für Photovoltaikmodule höherer Leistung hineinschalten, und Photovoltaikmodule, die unter dem Leistungsgrenzwert bleiben, in den String für Photovoltaikmodule geringer elektrischer Leistung hineinschalten. Der Leistungsgrenzwert kann z.B. fest vorgegeben sein oder als Mittelwert der erfassten elektrischen Leistungen sämtlicher Photovoltaikmodule ermittelt werden. Infolgedessen befinden sich in jedem String Photovoltaikmodule, die auf demselben oder auf einem ähnlichen Leistungsniveau arbeiten. Die den jeweiligen Strings zugeordneten Nachführeinrichtungen bzw. Tracker steuern diese Strings jeweils auf den Punkt maximaler Leistung. Da die Leistungsunterschiede der Photovoltaikmodule eines Strings geringer als bei herkömmlichen Photovoltaikanlagen sind, wird die Leistungsfähigkeit der Photovoltaikmodule insgesamt besser genutzt. Ein String mit voll leistenden Photovoltaikmodulen wird nämlich nicht durch ein verschattetes Photovoltaikmodul in der Energieeffizienz heruntergezogen. Andererseits gewährleistet der String, in dem die verschatteten Photovoltaikmodule zusammengeschaltet sind, dass die von diesen Photovoltaikmodulen gelieferte Leistung optimal ausgenutzt wird. Infolgedessen arbeitet die Photovoltaikanlage insgesamt effizienter.

Die Photovoltaikanlage kann einen einzigen Wechselrichter mit mehreren Trackern oder mehrere Wechselrichter mit jeweils einem und/oder mehreren Trackern aufweisen.

Gemäß einer Ausgestaltung des Verfahrens und der Photovoltaikanlage werden die von den verschiedenen Strings gelieferten Gleichströme je nach der spezifischen Leistung der Photovoltaikmodule des Strings einem Tracker mit einem auf die spezifische Leistung abgestimmten Arbeitsbereich zugeführt. Durch Zuführung der Energie aus den Strings zu Trackern, die einen auf die Leistung der Photovoltaikmodule des Strings abgestimmten Arbeitsbereich haben, kann die Effizienz des Verfahrens weiter gesteigert werden.

Gemäß einer Ausgestaltung des Verfahrens wird die Leistung der Solarzellen der Photovoltaikmodule erfasst, werden defekte Solarzellen eines Moduls abgeschaltet und die übrigen Solarzellen des Moduls zu einer Modulkette (auch "Modulstring" genannt) zusammengeschaltet. Bislang werden die einzelnen Zellen eines Photovoltaikmoduls über Modulstring-Dioden verwaltet. Dabei sind mehrere Solarzellen im Solarmodul zu einem String zusammengeschaltet und im Falle eines Ausfalls (z.B. eines "Hotspots") springt eine Diode an, die den Strom an dem Teil des Modulstrings vorbeileitet, zu dem die ausgefallene Solarzelle gehört. Dabei geht die Energie der intakten Solarzellen dieses Teils des Modulstrings verloren und beeinträchtigt die Effizienz des Photovoltaikmoduls. Dies wird dadurch überwunden, dass jede Zelle einzeln auf Leistung überprüft und im Modulstring zugeordnet oder von diesem abgeschaltet wird. Somit ist die Wirksamkeit des Photovoltaikmoduls besser als bei der herkömmlichen Vorgehensweise. Falls durch das Abschalten einzelner Solarzellen die Leistungsfähigkeit des Photovoltaikmoduls entsprechend herabgesetzt wird, wird das Photovoltaikmodul einem anderen String zugeschaltet.

Gemäß einer entsprechenden Ausgestaltung der Photovoltaikanlage weisen die Photovoltaikmodule Mittel zum Erfassen der elektrischen Leistung ihrer einzelnen Solarzellen, Mittel zum Erfassen von Solarzellen mit unzureichender elektrischer Leistung und Mittel zum Zusammenschalten der Solarzellen, die eine hinreichende elektrische Leistung liefern, zu einer Modulkette auf. Die Mittel zum Ermitteln von Solarzellen unzureichender Leistung und die Mittel zum Zusammenschalten sind bevorzugt integrierte elektrische Steuerungseinrichtungen der Photovoltaikmodule.

Gemäß einer weiteren Ausgestaltung wird die Temperatur der Photovoltaikmodule erfasst und werden Photovoltaikmodule, die aufgrund zu hoher Temperatur eine verminderte elektrische Leistung liefern, gekühlt und/oder Photovoltaikmodule, die aufgrund einer zu geringen Temperatur eine verminderte elektrische Leistung liefern, beheizt. Dieser Ausgestaltung liegt die Erkenntnis zugrunde, dass die Leistung von Photovoltaikmodulen stark von der Temperatur abhängt, mit der sie betrieben werden. Das Verfahren ermöglicht einen Betrieb der Photovoltaikmodule unter günstigeren bzw. optimalen Temperaturbedingungen.

Gemäß einer entsprechenden Ausgestaltung der Photovoltaikanlage weisen die Photovoltaikmodule Mittel zum Erfassen der Temperatur der Photovoltaikmodule sowie Mittel zum Aufheizen und/oder Kühlen der Photovoltaikmodule auf, sind die vorgenannten Mittel mit der mindestens einen Steuerungsvorrichtung verbunden und ist die Steuerungsvorrichtung so beschaffen, dass sie die Mittel zum Heizen und/oder Kühlen so steuert, dass die Photovoltaikmodule eine günstigere Betriebstemperatur erreichen.

Gemäß einer weiteren Ausgestaltung des Verfahrens werden die verschiedenen Photovoltaikmodule auf Abdeckung mit Schnee und/oder Eis überwacht und mit Schnee und/oder Eis bedeckte Photovoltaikmodule abgetaut. Hierdurch werden Beeinträchtigungen der Leistung der Photovoltaikmodule aufgrund Verschattung mit Schnee und/oder Eis überwunden. Beim Abtauen taut der Schnee entweder vollständig weg oder rutscht als Lawine vom Dach, auf dem die Photovoltaikmodule gegebenenfalls montiert sind. Ein weiterer Vorteil des Abtauens von Schneelasten ist, dass hierdurch eine statische Entlastung der Dachflächen stattfindet.

Gemäß einer entsprechenden Ausgestaltung der Photovoltaikanlage weisen die Photovoltaikmodule Mittel zum Erfassen einer Bedeckung der Photovoltaikmodule mit Schnee und/oder Eis und Mittel zum Abtauen auf, sind die vorgenannten Mittel mit der mindestens einen Steuerungsvorrichtung verbunden und ist die Steuervorrichtung so beschaffen, dass sie die Mittel zum Abtauen der Photovoltaikmodule einschaltet, bei denen die Mittel zum Erfassen einer Bedeckung Schnee und/oder Eis erfassen. Gemäß einer weiteren Ausgestaltung der Photovoltaikanlage weisen die Mittel zum Erfassen einer Bedeckung des Photovoltaikmoduls mit Schnee und/oder Eis einen Bedeckungssensor auf, der der lichtempfindlichen Fläche des Photovoltaikmoduls zugeordnet ist.

Gemäß einer weiteren Ausgestaltung der Photovoltaikanlage umfassen die Mittel zum Heizen und/oder Kühlen und/oder zum Abtauen der Photovoltaikmodule ein Luftklimagerät. Das Luftklimagerät ist vorzugsweise so beschaffen, dass es wahlweise einen Strom erwärmter oder gekühlter Luft liefert. Eine Entfeuchtung oder Befeuchtung des Luftstromes ist nicht erforderlich, kann aber vorgesehen werden, z.B. um die Bedingungen für die Entfernung einer Schicht aus Schnee oder Eis zu verbessern. Geeignete Luftklimageräte, mit denen geheizte und/oder gekühlte Luft zugeführt werden kann, sind kommerziell verfügbar. Gemäß einer weiteren Ausgestaltung umfassen die Mittel zum Heizen und/oder Kühlen und/oder Abtauen der Photovoltaikmodule Luftkammern an der Unterseite der Photovoltaikmodule. Über Luftkammern an der Unterseite der Photovoltaikmodule können diese effizient aufgeheizt und/oder gekühlt werden. Gemäß einer weiteren Ausgestaltung sind die Luftkammern mehrerer Photovoltaikmodule miteinander verbunden und werden gemeinsam mittels eines Luftklimagerätes temperiert. Die Luftkammern können seriell und/oder parallel miteinander verbunden sein.

Gemäß einer bevorzugten Ausgestaltung wird den Mitteln zum Heizen und/oder Kühlen und/oder Abtauen der Photovoltaikmodule und/oder zur Versorgung von Sensoren und/oder Steuerungseinrichtungen elektrische Energie über gesonderte Rückstromleitungen zugeführt. Die Rückstromleitungen können mit der elektrischen Energie versorgt werden, die die Solarmodule der Photovoltaikanlage liefern. Gemäß einer Ausgestaltung weist die Photovoltaikanlage einen elektrischen Energiespeicher auf, der aufgeladen werden kann, wenn die Photovoltaikmodule eine hinreichende elektrische Leistung liefern. Die geladene elektrische Energie wird zum Heizen und/oder Kühlen und/oder Abtauen von Photovoltaikvolumen und/oder zum Betreiben von Sensoren und/oder Steuerungseinrichtungen herangezogen, wenn die Photovoltaikanlage eine zu geringe oder keine elektrische Leistung liefert. Die elektrischen Energiespeicher sind bevorzugt elektrische Akkumulatoren. Gegebenenfalls können die elektrischen Rückstromleitungen aus dem elektrischen Versorgungsnetz gespeist werden.

Gemäß einer weiteren Ausgestaltung des Verfahrens werden schadhafte Photovoltaikmodule nicht in einen String hineingeschaltet. Hierdurch wird eine

Beeinträchtigung der Leistung der Strings durch schadhafte Photovoltaikmodule vermieden.

Gemäß einer entsprechenden Ausgestaltung der Photovoltaikanlage ist die Steuerungsvorrichtung so beschaffen, dass sie die erfassten Leistungswerte mit einer unteren Leistungsgrenze vergleicht und Photovoltaikmodule, die die untere Leistungsgrenze unterschreiten, nicht in ein Gleichspannungsnetz hineinschaltet.

Gemäß einer weiteren Ausgestaltung der Photovoltaikanlage hat diese eine zentrale Steuerungsvorrichtung (auch "Stringbox" genannt), die mit verschiedenen Photovoltaikmodulen verbunden ist. Eine zentrale Steuerungsvorrichtung hat den Vorteil, dass sie die Photovoltaikmodule in Abhängigkeit von den aktuellen Leistungen sämtlicher Photovoltaikmodule der Anlage zu verschiedenen Strings zusammengeschalten kann. Beispielsweise kann die zentrale Steuerungsvorrichtung die Leistung der Photovoltaikmodule durch Vergleich mit der mittleren Leistung sämtlicher Photovoltaikmodule bewerten. Hierdurch kann berücksichtigt werden, ob eine geringe Leistung eines Photovoltaikmoduls auf einer insgesamt geringen Sonneneinstrahlung oder darauf beruht, dass das jeweilige Photovoltaikmodul verschattet ist. Dementsprechend kann die Steuerungsanlage die untere Leistungsgrenze für das Hinzuschalten von Photovoltaikmodulen in ein Gleichspannungsnetz in Abhängigkeit von den aktuellen Leistungen sämtlicher Photovoltaikmodule ermitteln.

Ferner kann eine zentrale Steuerungsvorrichtung ermitteln, ob die Leistung eines Strings aus Photovoltaikmodulen von einem Wechselrichter mit Tracker noch verarbeitet werden kann. Ist der Wechselrichter mit Tracker für eine geringere Leistung ausgelegt, kann die zentrale Steuerungsvorrichtung einen Teil der Photovoltaikmodule in einem weiteren String zusammenschalten. Hierfür kann die zentrale Steuerungsvorrichtung so beschaffen sein, dass sie einen Teil der Photovoltaikmodule in ein weiteres Gleichspannungsnetz (auch "Ausweichleitung" genannt) hineinschaltet, das mit einem weiteren Tracker verbunden ist.

Grundsätzlich ist es aber auch möglich, jedem Photovoltaikmodul eine eigene Steuerungsvorrichtung zuzuordnen, die entscheidet, welchem String die Photovoltaikanlage zugeordnet ist. Dezentrale Steuerungsvorrichtungen können grundsätzlich nur anhand absoluter Leistungswerte entscheiden, welchem String das Photovoltaikmodul zugeschaltet wird bzw. ob ein Photovoltaikmodul überhaupt einem String zugeschaltet wird.

Gemäß einer weiteren Ausgestaltung ist die mindestens eine Steuerungsvorrichtung so beschaffen, dass sie die von den Mitteln zum Erfassen der elektrischen Leistung und/oder von den Mitteln zum Erfassen von Solarzellen unzureichender Leistung und/oder von den Mitteln zum Erfassen der Temperatur und/oder von den Mitteln zum Erfassen einer Bedeckung der Photovoltaikmodule erfassten Daten und/oder die von der Steuerungsvorrichtung an die Schaltvorrichtungen und/oder Mittel zum Aufheizen und/oder Kühlen und/oder Abtauen gesandten Steuerungsdaten abspeichert (z.B. in einem Halbleiterspeicher) und/oder Mittel zum Ausgeben (z.B. eine Anzeigeeinrichtung oder eine Datenschnittstelle) dieser Daten aufweist.

Gemäß einer weiteren Ausgestaltung ist die Steuerungsvorrichtung mit den Photovoltaikmodulen bzw. den Mitteln zum Erfassen der elektrischen Leistung und/oder den Mitteln zum Erfassen der Temperatur und/oder den Mitteln zum Aufheizen und/oder Kühlen und/oder den Mitteln zum Erfassen einer Bedeckung mit Eis und/oder Schnee und/oder den Mitteln zum Abtauen über Kabel und/oder über Funk verbunden.

Gemäß einer bevorzugten Ausgestaltung weist die Photovoltaikanlage zwei Gleichspannungsnetze auf. Grundsätzlich ist es aber auch möglich, Photovoltaikmodule zu mehr als zwei Strings zusammenzuschalten. Beispielsweise kann eine Photovoltaikanlage mit drei Strings bereitgestellt werden, um mit einer Ausweichleitung eventuell entstehende Schieflasten aufzufangen.

Die Erfindung wird nachfolgend anhand der anliegenden Zeichnung von Ausführungsbeispielen näher erläutert.
- Fig. 1: eine Photovoltaikanlage in einem schematischen Blockbild;
- Fig. 1.1: wie Fig. 1 jedoch mit veränderter Verschattung
- Fig. 2: einen Ausschnitt der Photovoltaikanlage von Fig. 1;
- Fig. 3.1: ein Photovoltaikmodul der Photovoltaikanlage in einem vergrößerten Blockbild;
- Fig. 3.2: eine Nachrüsteinheit mit Schaltvorrichtungen und Sensoren für ein Photovoltaikmodul im Blockbild:
- Fig.3.3.: eine Nachrüsteinheit mit Schaltvorrichtungen für ein Photovoltaikmodul im Blockbild;
- Fig. 4: ein Photovoltaikmodul mit Bedeckungssensor und Luftkammersystem in einem grobschematischen Vertikalschnitt;
- Fig. 5: dasselbe Luftkammersystem in einer grobschematischen Unteransicht.

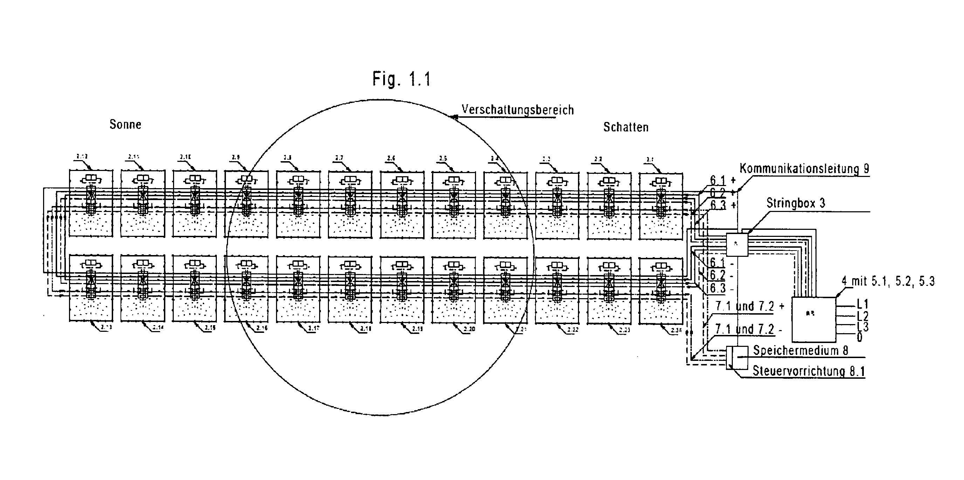

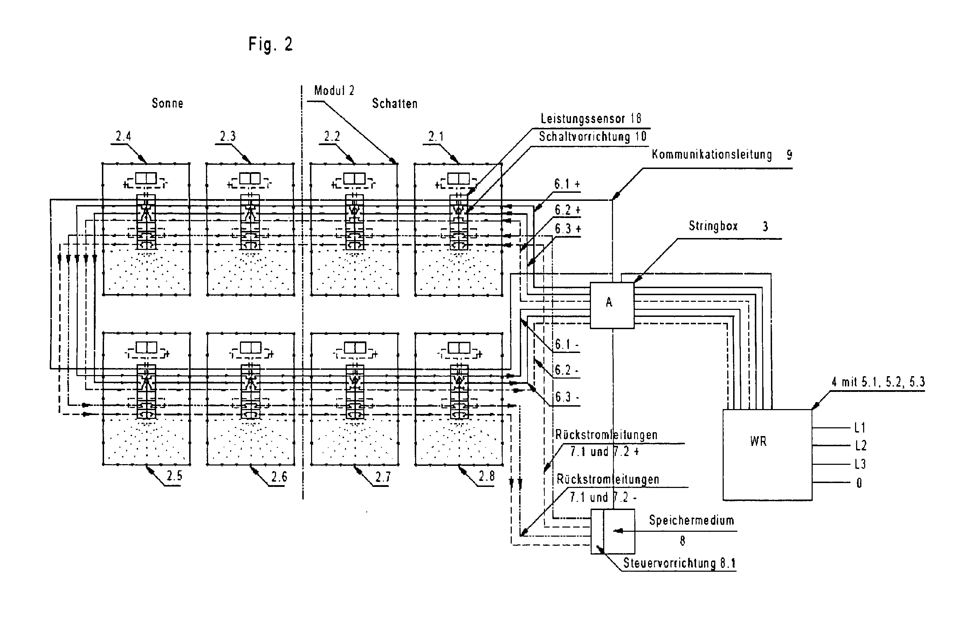

Gemäß Fig. 1, 1.1 und 2 umfasst eine Photovoltaikanlage 1 eine Vielzahl Photovoltaikmodule 2. Ferner weist sie eine zentrale elektrische Steuerungsvorrichtung 3 auf, die nachfolgend auch als "Stringbox" bezeichnet wird.

Zudem ist ein Wechselrichter 4 mit mehreren Trackern 5.1, 5.2, 5.3 vorhanden.

Des Weiteren umfasst die Photovoltaikanlage 1 gemäß Fig. 1 und 1.1 drei Gleichspannungsnetze 6.1, 6.2, 6.3 Sämtliche Photovoltaikmodule 2 sind seriell in jedes Gleichspannungsnetz 6.1, 6.2 und 6.3 einbezogen.

Die elektrischen Gleichspannungsnetze 6.1, 6.2 und 6.3 sind über die elektrische Steuerungseinrichtung 3 mit dem Wechselrichter 4 mit Trackern 5.1, 5.2 und 5.3 verbunden. Dabei ist jedem Gleichspannungsnetz 6.1, 6.2, 6.3 genau ein Tracker 5.1, 5.2, 5.3 zugeordnet. Bei Großanlagen können auch noch mehr Leitungen 6.4 usw. verwendet werden.

Ferner weist die Photovoltaikanlage 1 zwei Rückstromleitungsnetze 7.1, 7.2 auf. Sämtliche Photovoltaikmodule 2 sind seriell in jedes Rückstromleitungsnetz 7.1, 7.2 einbezogen. Das System kann auch mehr als zwei Rückstromleitungen 7.3 usw. aufweisen.

Die Rückstromleitungsnetze 7.1, 7.2 sind jeweils beide an einen elektrischen Energiespeicher 8 angeschlossen. Dem Energiespeicher 8 ist eine Steuereinheit 8.1 zur Regulierung der Spannung bei wechselnden Lastfällen nachgeschaltet.

Ferner umfasst die Photovoltaikanlage 1 elektrische Kommunikationsleitungen 9. Diese verbinden jedes Photovoltaikmodul 2 mit der elektrischen Steuerungsvorrichtung 3, dem Wechselrichter mit Trackern 4, 5.1, 5.2, 5.3 und dem elektrischen Energiespeicher 8.

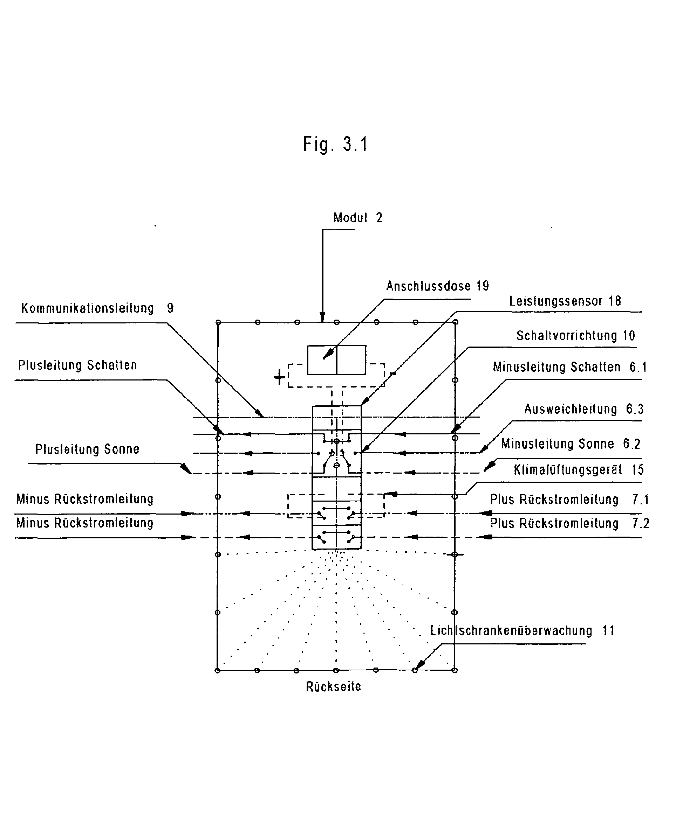

Gemäß Fig. 3.1 weist jedes Photovoltaikmodul 2 elektrische Schaltvorrichtungen 10 auf, mit denen die Solarzellen jedes Photovoltaikmoduls 2 in eines der Gleichspannungsnetze 6.1, 6.2, 6.3 hineingeschaltet werden können. In Fig. 3.1 sind die beiden Anschlussleitungen des Gleichspannungsnetzes 6.1 mittels der Schaltvorrichtungen 10 auf Durchgang geschaltet und die Anschlussleitungen des Gleichspannungsnetzes 6.2 sind mittels der Schaltvorrichtungen 10 mit den Solarzellen des Photovoltaikmoduls 2 verbunden.

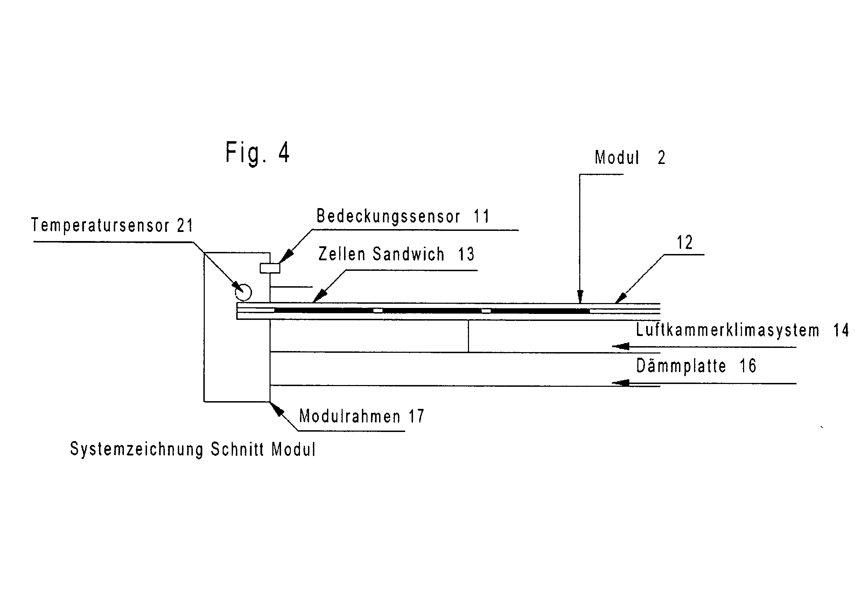

Gemäß Fig. 4 hat zudem jedes Photovoltaikmodul 2 einen Bedeckungssensor 11, der überwacht, ob die lichtempfindliche Fläche 12 bzw. die nach außen gerichtete Scheibe des Photovoltaikmoduls 2 mit Schnee oder Eis bedeckt ist. Der Bedeckungssensor 11 ist ein Sensor, der so beschaffen ist, dass er die Bedeckung der lichtempfindlichen Fläche 12 mit Schnee oder Eis erfassen kann. Er ist z.B. eine Lichtschranke, die von einer Schicht aus Schnee oder Eis auf der lichtempfindlichen Fläche 12 unterbrochen wird oder ein auf die lichtempfindliche Fläche 12 gerichteter Abstandssensor, der einen kürzeren Abstand misst, wenn Schnee oder Eis die lichtempfindliche Fläche 12 bedeckt, als wenn sie frei davon ist.

An der Rückseite weist jedes Photovoltaikmodul 2 unterhalb der Solarzellen 13 eine Anordnung von Luftkammern 14 auf, die von einem Luftklimagerät 15 gespeist werden. Im Beispiel ist jedem Photovoltaikmodul 2 ein Luftklimagerät 15 zugeordnet. Unter der Luftkammer 14 befindet sich Dämmmaterial bzw. eine Dämmplatte 16. Der Schichtenaufbau aus Solarzellen 13, Luftkammern 14 und Dämmplatte 16 ist von einem Modulrahmen 17 eingefasst.

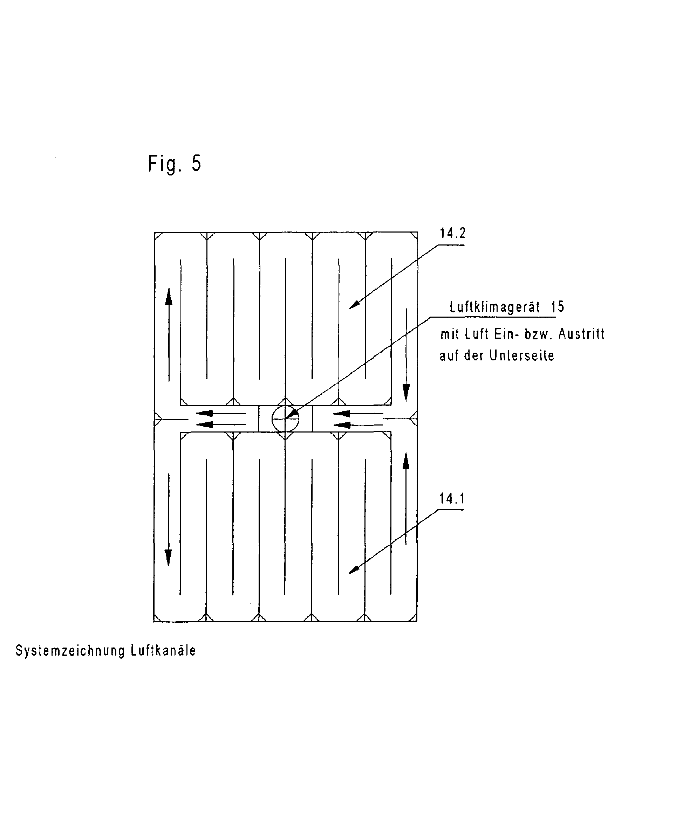

Gemäß Fig. 5 wird temperierte Luft jeweils mäanderförmig über die beiden Hälften des Photovoltaikmoduls 2 geleitet. Hierfür wird die zugeführte Warmluft oder Kaltluft in zwei Teilströme aufgespaltet, wobei jeder Teilstrom einer der beiden Hälften zugeführt wird. Nach dem Durchströmen durch die mäanderförmigen Luftkammern 14.1, 14.2 werden die beiden Teilströme wieder zusammengeführt und treten aus dem Photovoltaikmodul 2 aus.

Darüber hinaus hat gemäß Fig. 3.1 jedes Photovoltaikmodul 2 Mittel zum Erfassen 18 der vom Photovoltaikmodul 2 gelieferten Leistung 18, die z.B. jeweils den aktuellen Strom und die aktuelle Spannung des jeweiligen Photovoltaikmoduls 2 messen. Die Mittel zum Erfassen 18 (auch "Leistungssensor" genannt) sind zwischen die Schaltvorrichtungen 10 und eine Anschlussdose 19 für die elektrische Verbindung mit den Solarzellen 13 des Photovoltaikmoduls 2 geschaltet.

Die Mittel zum Erfassen der gelieferten Leistung 18, die elektrischen Schaltvorrichtungen 10, der Bedeckungssensor 11 und das Klimagerät 15 sind an die Kommunikationsleitung 9 angeschlossen.

Die Mittel zum Erfassen der elektrischen Leistung 18 ermitteln fortlaufend oder wiederholt die aktuelle Leistung jedes Photovoltaikmoduls 2. Diese Information gelangt über die Kommunikationsleitung 9 an die elektrische Steuerungsvorrichtung 3. Je nach dem Leistungsniveau des Photovoltaikmoduls 2 wird dieses von der elektrischen Steuerungsvorrichtung 3 dem Gleichspannungsnetz 6.1 für verschattete Photovoltaikmodule 2 oder 6.2 oder 6.3 für von der Sonne beschienene Photovoltaikmodule 2 zugeordnet. Über die Kommunikationsleitung 9 und die elektrischen Schaltvorrichtungen 10 der Photovoltaikmodule 2 werden diese in das jeweilige Gleichspannungsnetz 6.1, 6.2 oder 6.3 hineingeschaltet. Von der Sonne beschienene Photovoltaikmodule 2 werden in das Gleichspannungsnetz 6.3 hineingeschaltet, wenn das Hineinschalten in das Gleichspannungsnetz 6.2 dieses überlasten würde. Eventuell entstehende Schieflasten können hierdurch aufgefangen werden.

In Fig. 2 ist eine beispielhafte Situation gezeigt, in der die Photovoltaikmodule 2.3, 2.4, 2.5 und 2.6 von der Sonne beschienen und die Photovoltaikmodule 2.1, 2.42, 2.7 und 2.8 verschattet sind. Dementsprechend ist die erstgenannte Gruppe Photovoltaikmodule 2 in das Gleichspannungsnetz 6.2 und die zweitgenannte Gruppe in das Gleichspannungsnetz 6.1 hineingeschaltet.

Bei Veränderungen der Verschattungssituation wird dies von den Photovoltaikmodulen 2 über die Kommunikationsleitung 9 an die Stringbox 3 gemeldet und diese entscheidet, in welches Gleichspannungsnetz 6.1, 6.2 oder 6.3 der Strom der Photovoltaikmodule 2 eingeleitet werden soll. Über die Kommunikationsleitung 9 wird diese Entscheidung an die Photovoltaikmodule 2 weitergegeben, die jeweils in die entsprechenden Gleichspannungsnetze 6.1, 6.2, 6.3 hineingeschaltet werden.

Der Bedeckungssensor 11 meldet der elektrischen Steuerungsvorrichtung 3 eine Bedeckung der Photovoltaikmodule 2 mit Schnee oder Eis über die Kommunikationsleitung 9. Die elektrische Steuerungsvorrichtung 3 schaltet über die Kommunikationsleitung 9 die Klimageräte 15 der mit Schnee oder Eis bedeckten Photovoltaikmodule 2 ein, bis diese abgetaut sind. Dies meldet der Bedeckungssensor 11 über die Kommunikationsleitung 9 der elektrischen Steuerungsvorrichtung 3 und diese schaltet die Klimageräte 15 der abgetauten Photovoltaikmodule 2 ab.

Die elektrische Energie für das Abtauen der Photovoltaikmodule 2 wird diesen über die Rückstromleitungen 7.1 zugeführt, die von dem Energiespeicher 8 gespeist werden. Die elektrische Energie für den Bedeckungssensor 11 wird über die weitere Rückstromleitung 7.2 den Photovoltaikmodulen 2 zugeführt. Der elektrische Energiespeicher 8 stellt sicher, dass die Photovoltaikanlage 1 auch dann abgetaut werden kann, wenn sie keine elektrische Leistung liefert.

Das dritte Gleichspannungsnetz 6.3 kann auch so genutzt werden, dass es in dem Fall, in dem sonst eine Vielzahl Photovoltaikmodule 2 in eines der beiden Gleichspannungsnetze 6.1, 6.2 hineingeschaltet würden, einen Teil dieser Photovoltaikmodule 2 aufnimmt. Dies ermöglicht eine Aufteilung von der Sonne beschienener oder verschatteter Gleichspannungsmodule 2 in verschiedene Gruppen mit Photovoltaikmodulen verschiedener Leistung. Beispielsweise werden von der Sonne beschienene Photovoltaikmodule 2, die einen bestimmten Leistungsgrenzwert erreichen, in das Gleichspannungsnetz 6.2 und Photovoltaikmodule, die den Leistungsgrenzwert unterschreiten, in das Gleichspannungsnetz 6.3 hineingeschaltet.

Eine weitere Differenzierung der Photovoltaikmodule 2 nach der von ihm gelieferten Leistung ist möglich, wenn weitere Gleichspannungsnetze 6.4 usw. und zugeordnete Wechselrichter 4 mit Tracker 5.4 usw. vorgesehen werden. Hierdurch wird eine weitere Verbesserung der Effizienz der Photovoltaikanlage 1 erreicht.

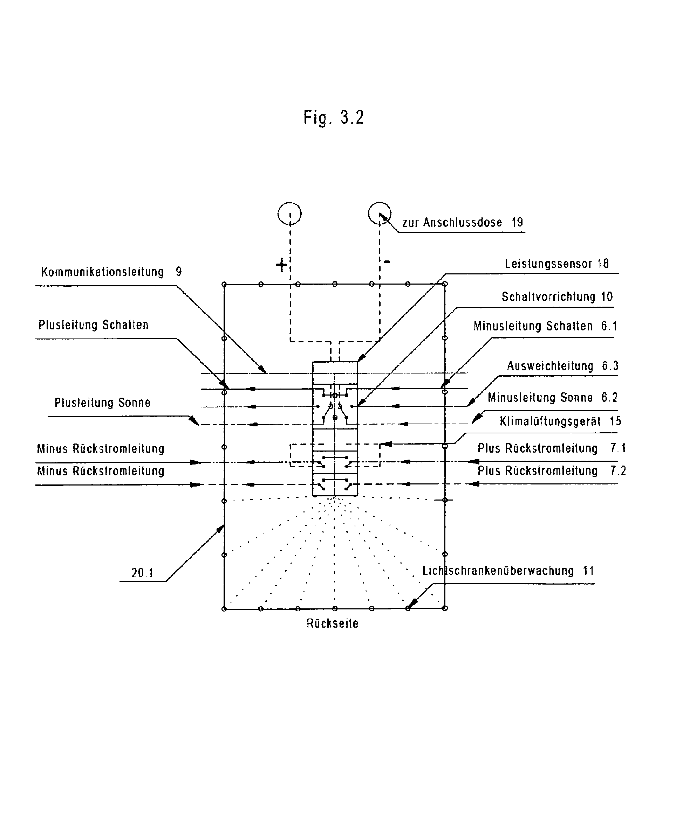

Gemäß Fig. 3.1 sind die Schaltvorrichtungen 10, der Bedeckungssensor 11 und die Mittel zum Erfassen der elektrischen Leistung 18 baulich in das Photovoltaikmodul 2 integriert. Gemäß Fig. 3.2 sind die Schaltvorrichtungen 10, der Bedeckungssensor 11 und die Mittel zum Erfassen der elektrischen Leistung 18 Teil einer Nachrüsteinheit 20.1, mit der ein Photovoltaikmodul 2 nachrüstbar ist. Die Nachrüsteinheit 20.1 ist beispielsweise in einem besonderen Gehäuse untergebracht, das am Rahmen 17 oder an der Unterseite eines Photovoltaikmoduls 2 fixierbar ist. Die Nachrüsteinheit 20.1 wird in der elektrischen Anschlussdose 19 des Photovoltaikmoduls 2 verdrahtet.

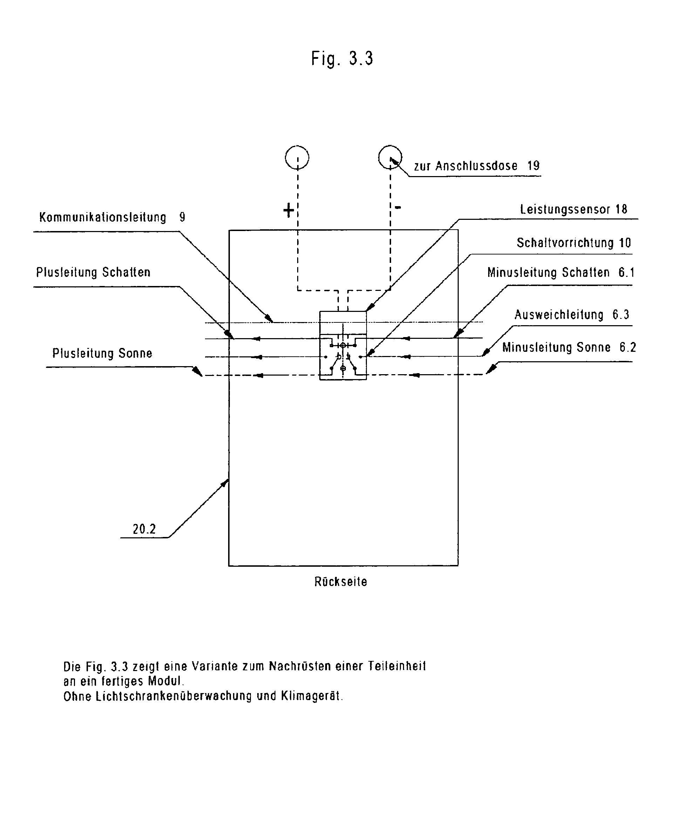

Fig. 3.3 zeigt eine weitere Nachrüsteinheit 20.2 für ein Photovoltaikmodul 2, das lediglich die Schaltvorrichtungen 10 und die Mittel zum Erfassen der elektrischen Leistung 18 umfasst. Die Nachrüsteinheit 20.2 kann ebenfalls elektrisch an die Anschlussdose 19 eines Photovoltaikmoduls 2 angeschlossen werden. Die Nachrüsteinheit 20.2 ist beispielsweise in einem besonderen Gehäuse untergebracht und am Rahmen 17 oder an der Unterseite eines Photovoltaikmoduls 2 fixierbar.

Das Photovoltaikmodul 2 bzw. eine Nachrüsteinheit 20.1, 20.2 kann zudem mit weiteren Sensoren versehen sein. Beispielsweise ist ein Mittel zum Erfassen der Temperatur des Photovoltaikmoduls bzw. ein Temperatursensor 21 vorhanden, der über die Kommunikationsleitung 9 mit der Steuerungseinrichtung 43 verbunden ist.

Nachfolgend werden weitere Merkmale und vorteilhafte Ausführungen des erfindungsgemäßen Verfahrens und der erfindungsgemäßen Photovoltaikanlage erläutert.

### Konzept

Die Erfindung bewirkt eine verbesserte Effizienz von Photovoltaikanlagen in Verschattungssituationen. Hierfür werden folgende vorzugsweise Mittel eingesetzt:
1. Ein intelligentes DC (Gleichstrom) PV (Photovoltaik) Strom Management mit einem "intelligenten Modul" und "intelligenten PV Stringboxen" auf Basis eines "PV Mehrkreis Stromsystems".
   Dies bedeutet die flexible Loslösung von einem starren System. Mit dem flexiblen System kann man Verschattungsflächen in den Generator integrieren und verschneite Flächen abtauen ohne bzw. geringe Verluste in Kauf nehmen zu müssen.
   Dabei wird von dem Modul selbst festgestellt, ob es verschattet ist oder die volle Sonnenenergie hat. Diese Information geht dann über eine Kommunikationsleitung zur Stringbox. Diese Stringbox entscheidet, in welche Leitung die Energie eingeleitet werden soll. Bei einer Verschattung bekommt das Modul von der Stringbox die Information, sich von der Hauptleitung abzuschalten und die Minderenergie in eine eigene Leitung einzuleiten. Somit ist gewährleistet, dass der Hauptstring nur voll leistende Module hat und nicht durch ein verschattetes Modul in der Energieeffizienz heruntergezogen wird. Selbst die Fehlersuche nach defekten Modulen wird erleichtert, weil die Informationen, über die Stringbox, an die Schnittstelle des Wechselrichters (WR) gehen. Sollte also ein Modul soweit defekt sein und den ganzen String wie bisher unterbrechen, das heißt, dass der gesamte String keine Energie mehr liefert, kann die neue Photovoltaikanlage weiter Energie produzieren und das schadhafte Modul aus dem String nehmen. Ebenso kann Strom zum Heizen oder Kühlen zurückgeführt werden.
2. "Intelligentes Solarmodul", All in one Modul Dieses Modul hat eine eigene Steuerung über Mikrochips in der Leistungssensorbox 18. Das Modul überwacht sich selbst, gibt selbst gemessene Daten (Strom und Spannung) über eine Kommunikationsleitung an die "intelligente Stringbox" und schaltet den Stromfluss in die entsprechenden Ausgangsleitungen über Relais oder andere Mittel der Schaltvorichtungsbox 10 in das "PV Mehrkreis Stromsystem". So kann ein verschattetes oder defektes Modul, welches sich vom Erzeuger in einen Verbraucher verwandeln kann, von dem Hauptstring abgeschaltet und ggf. dem Nebenstring zugeschaltet werden. Bisher werden die einzelnen Zellen im Modul über Modulstring Dioden verwaltet. Das heißt, mehrere Zellen sind zu einem String im Modul verschaltet und im Fall eines Ausfalls, "z.B. Hot Spot", springt die Diode an, fungiert als Weiche und lenkt den Strom der verbleibenden Modulstrings dann an dem ausgefallenen Modulstring vorbei. Dabei geht aber die Energie der intakten Zellen in diesem Modulstring verloren und zieht die Hauptstringbilanz nach unten. Bei dem "intelligenten Solarmodul" wird jede Zelle einzeln angesteuert und auf deren Leistung hin überprüft und mittels eines "wenn-dann-Verfahrens" zu- oder abgeschaltet. Somit ist die Effizienz des Moduls nicht ganz gefährdet. Und der Minderstrom wird in die entsprechende Leitung gespeist, damit der Hauptstring seine 100 % Arbeit verrichten kann.
3. "Intelligente PV Stringbox"
   Diese Stringbox hat ebenfalls eine eigene Steuerung mittels Mikrochips und Relais. Sie erhält von den Modulen und von dem WR Informationen über deren Leistungsfähigkeit. Anhand dieser Informationen entscheidet die Stringbox, in welchen Stromkreis die gewonnene Energie fließen soll. Die Stringbox ist mit den Modulen, den anderen Stringboxen und dem Wechselrichter über eine Kommunikationsleitung verbunden. Des Weiteren können über die Kommunikationsleitung Temperaturfühler und Windmessgeräte angeschlossen werden. Insgesamt übernimmt diese Stringbox einen Teil der Verwaltung und gibt spezifische Daten zum WR zur weiteren Verwaltung und Auswertung weiter. Der WR übernimmt die Masterfunktion im Master-Slave Prinzip.
4. "PV Mehrkreis Stromsystem"
   Dieses PV Mehrkreis Stromsystem nimmt über verschiedene Leitungen die unterschiedlichen Energieströme auf und leitet diese dann über die PV Stringbox mit weiteren Mehrkreisen zum Wechselrichter, zu den entsprechenden Trackern, welche somit in ihren Arbeitsbereichen effizient arbeiten können. Im Umkehrschluss kann aber auch Strom zu dem Modul geleitet werden. Dieser wird benötigt, um Modulkontrollen auf Schnee und Raureif durchzuführen bzw. das Modul zu heizen oder kühlen. Das Verbindungskabel hat mindestens drei Adern a 4-6 mm² plus ein eigenständiges Netzwerkkabel. Dieses Verbindungskabel hat einen eigenen Systemstecker für Plus und Minus Ein- bzw. Ausgänge.
   Die Daten der Messgeräte (Temperaturfühler, Windmesser und Einstrahlmessgerät" werden ebenfalls über die Kommunikationsleitung zur Stringbox geleitet. Die Kommunikation kann auch über W-LAN stattfinden.
5. "PV Modulheizung und Kühlung"
   Als Zusatzoption hat dieses Modul eine "Modulheizung" für Frostzustände (Raureif, Schnee). Diese Zusatzoption kann aber auch im Umkehrschluss die Module bei Hitze kühlen. Es wird dabei Strom zurück zum Modul geschickt, um es kurzzeitig zu erwärmen um dann abgetaut wieder Leistung bringen zu können. Die Kühlung könnte deshalb sinnvoll werden, weil ein kaltes Modul mehr Leistung bringt als ein warmes. Die Überwachung, ob Raureif oder Schnee die Leistungsbereitschaft des Moduls beeinträchtigen, wird mittels Infrarotstrahlen, die ca. 5 mm über dem Modul von mehreren Produkten aus arbeiten, in Zusammenarbeit mit einem Temperaturfühler durchgeführt oder manuell durch Besichtigung des Betreibers und manueller Einschaltung betätigt. Außerdem wird eine Zeitschaltuhr benötigt, damit in den Wintermonaten, wenn das Modul durch Raureif oder Schnee erst gar nicht anfängt zu arbeiten, dem Wechselrichter signalisiert werden kann, dass die Module zurückfließenden Strom brauchen, um mittels Bedeckungssensor und Temperaturfühler die nötige Kontrolle auf Schnee oder Raureif durchzuführen.
   Das Heiz- und Kühlsystem wird mit einem vollflächigen Luftkammersystem, Stärke ca. 15 mm, unterhalb der Zellen versehen. In diesem Luftkammerklimasystem kann, je nach Bedarf, warme oder kalte Luft mittels Luftklimagerät zugeführt werden und so das Modul auf die gewünschte Betriebstemperatur eingestellt werden. Ist das Modul schneefrei - diese Information wird mit den Bedeckungssensor und der Leistung der Zellen ermittelt - wird die Heizung abgeschaltet. Der Schnee wird entweder wegtauen oder als Lawine vom Dach rutschen. Ein weiterer Betrachtungspunkt ist, dass durch das Abtauen des Schnees eine statische Entlastung der Dachflächen stattfindet.
   Die Überwachung der Kühlfunktion wird mittels Temperaturfühler geregelt. Da das Modul sich selbst überwacht, kann es ab einer vordefinierten Temperatur entscheiden, die Kühlung einzuleiten, um wirtschaftlich zu arbeiten.
6. Wechselrichter zu diesem System
   Bei diesem System hat der Wechselrichter vorzugsweise einen Ausweichtracker, um bei extremen Verschattungsveränderungen flexibel zu bleiben und die Überkapazitäten aufzunehmen.
   Weiterhin ist er vorzugsweise in der Lage, Strom in begrenzten Mengen für die Heizung, Kühlung und Überwachung zurückfließen zu lassen. Wie die
   Steuerung dazu im Einzelnen aussieht, wird die Forschung ergeben. Der WR ist mit den PV Stringboxen über Netzwerkkabel verbunden.
   Der Arbeitsbereich muss auch so groß sein, wie z.B. der Tripower von SMA, dass ein String bei der Anzahl der Module, die ihm dann zugeführt werden, bedingt flexibel sein kann.
7. Für das Photovoltaikmodul von Fig. 3.1 gelten vorzugsweise folgende Spezifikationen:
   Verbindungskabel
      Min. 2 Adern und mehr a 4 bzw. 66mm² für 6.1 und 6.2 hier 6 Adern plus 4 Adern für 7.2 Leistungen + 1 Netzwerkkabel.

Die Kabel kommen wie bisher aus der Anschlussdose und gehen direkt über den Leistungssensor 18 in die Schaltvorrichtung 10. Die Schaltvorrichtungen sind mit kurzen Ein- und Ausgangsleitungen versehen, an deren Enden ein Systemstecker für alle Leitungen montiert ist.

Die Rückstromleitung 7.1 ist für das Klimalüftungsgerät und die Rückstromleitung 7.2 ist für die Lichtschrankenüberwachung vorgesehen. Die Anschlussstecker werden hierbei mit den Sonnen- und Schattenleitungen in einem Multistecker zusammen gefasst. Der Strom für die Rückführung kommt aus einem Speichermedium. Die jeweiligen Spannungen für unterschiedliche Lastfälle werden von einem Zusatzstreuergerät geregelt. Bei dieser Darstellung ist die Sonnenleitung am Modul angeschlossen und die Schattenleitung auf Durchgang. Ebenso ist die Überwachung und die Klimaregelung eingeschaltet.

## Patentansprüche

1. Verfahren zum Betreiben einer Photovoltaikanlage mit mehreren Ketten aus jeweils mehreren zusammengeschalteten Photovoltaikmodulen und mindestens einem von den Ketten gespeisten Wechselrichter mit mehreren Nachführeinrichtungen, bei dem
● die von einzelnen Photovoltaikmodulen gelieferten elektrischen Leistungen ermittelt werden,
● die Photovoltaikmodule entsprechend den von ihnen gelieferten Leistungen zu verschiedenen Ketten zusammengeschaltet werden, wobei jede Kette aus Photovoltaikmodulen besteht, die eine für die Kette spezifische Leistung liefern, und
● die von den verschiedenen Ketten gelieferten Gleichströme verschiedenen Nachführeinrichtungen zugeführt und über den mindestens einen Wechselrichter in einen Wechselstrom umgewandelt werden.

2. Verfahren nach Anspruch 1, bei dem die von den verschiedenen Ketten gelieferten Gleichströme je nach der spezifischen Leistung der Photovoltaikmodule der Kette einer Nachführeinrichtung mit einem auf die spezifische Leistung der Photovoltaikmodule abgestimmten Arbeitsbereich zugeführt werden.

3. Verfahren nach Anspruch 1 oder 2, bei dem die Leistung der Solarzellen der Photovoltaikmodule erfasst wird, defekte Solarzellen eines Moduls abgeschaltet werden und die übrigen Solarzellen des Moduls zu einer Modulkette zusammengeschaltet werden.

4. Verfahren nach einem der Ansprüche 1 bis 3, bei dem die Temperatur der Photovoltaikmodule erfasst wird und Photovoltaikmodule, die aufgrund zu hoher Temperatur eine verminderte elektrische Leistung liefern, gekühlt und/oder Photovoltaikmodule, die aufgrund einer zu geringen Temperatur eine verminderte elektrische Leistung liefern, geheizt werden.

5. Verfahren nach einem der Ansprüche 1 bis 4, bei dem die Photovoltaikmodule auf Abdeckung mit Schnee und/oder Eis überwacht werden und mit Schnee und/oder Eis bedeckte Photovoltaikmodule abgetaut werden.

6. Verfahren nach einem der Ansprüche 1 bis 5, bei dem schadhafte Photovoltaikmodule nicht in eine Kette hineingeschaltet werden.

7. Photovoltaikanlage mit mehreren Ketten aus jeweils mehreren zusammengeschalteten Photovoltaikmodulen mit
● mehreren Photovoltaikmodulen (2),
● Mitteln zum Erfassen der von den einzelnen Photovoltaikmodulen (2) gelieferten elektrischen Leistungen (18),
● mehreren Gleichspannungsnetzen (6.1, 6.2, 6.3), von denen jedes für Photovoltaikmodule (2) mit einer spezifischen Leistung vorgesehen ist, die jeweils mit jedem Photovoltaikmodul (2) verbunden sind,
● mindestens einem Wechselrichter (4) mit mehreren Nachführeinrichtungen (5.1, 5.2, 5.3), die jeweils mit einem Gleichspannungsnetz (6.1, 6.2, 6.3) verbunden sind,
● elektrischen Schaltvorrichtungen (10) zwischen den Photovoltaikmodulen (2) und den Gleichspannungsnetzen (6.1, 6.2, 6.3) und
● mindestens einer mit den elektrischen Schaltvorrichtungen (10) und den Mitteln zum Erfassen der gelieferten elektrischen Leistungen (18) verbundenen elektrischen Steuerungsvorrichtung (3), die so beschaffen ist, dass sie Photovoltaikmodule (2) entsprechend den von ihnen gelieferten Leistungen jeweils in das Gleichspannungsnetz (6.1, 6.2, 6.3) hineinschaltet, das für Photovoltaikmodule (2) mit derselben spezifischen Leistung vorgesehen ist.

8. Photovoltaikanlage nach Anspruch 7, bei der der Arbeitsbereich der Nachführeinrichtung (5.1, 5.2, 5.3) auf die spezifische Leistung der Photovoltaikmodule (2) abgestimmt ist, die für das Gleichspannungsnetz (6.1, 6.2, 6.3) vorgesehen sind, mit dem die Nachführeinrichtung (5.1, 5.2, 5.3) verbunden ist.

9. Photovoltaikanlage nach Anspruch 7 oder 8, bei der die Photovoltaikmodule (2) Mittel zum Erfassen der elektrischen Leistung ihrer einzelnen Solarzellen, Mittel zum Ermitteln von Solarzellen mit unzureichender Leistung und Mittel zum Zusammenschalten der Solarzellen, die eine hinreichende elektrische Leistung liefern, zu einer Modulkette aufweisen.

10. Photovoltaikanlage gemäß einem der Ansprüche 7 bis 9, bei der die Photovoltaikmodule (2) Mittel zum Erfassen der Temperatur (21) der Photovoltaikmodule (2) sowie Mittel zum Aufheizen und/oder Kühlen (15) der Photovoltaikmodule (2) aufweisen, die vorgenannten Mittel mit der mindestens einen Steuerungsvorrichtung (3) verbunden sind und die Steuervorrichtung (3) so beschaffen ist, dass sie die Mittel zum Heizen und/oder Kühlen (15) so steuert, dass die Photovoltaikmodule eine Betriebstemperatur erreichen, bei der sie eine höhere elektrische Leistung liefern.

11. Photovoltaikanlage gemäß einem der Ansprüche 7 bis 10, bei der die Photovoltaikmodule (2) Mittel zum Erfassen einer Bedeckung (11) der Photovoltaikmodule (2) mit Schnee und/oder Eis und Mittel zum Abtauen (15) aufweisen, die vorgenannten Mittel mit der mindestens einen Steuerungsvorrichtung (3) verbunden sind und die Steuerungsvorrichtung so beschaffen ist, dass sie die Mittel zum Abtauen (15) der Photovoltaikmodule (2) einschaltet, bei denen die Mittel zum Erfassen einer Bedeckung (11) eine Bedeckung mit Schnee und/oder Eis erfassen.

12. Photovoltaikanlage nach Anspruch 11, bei der die Mittel zum Erfassen einer Bedeckung (11) des Photovoltaik-Moduls (2) mit Schnee und/oder Eis einen der lichtempfindlichen Fläche (12) des Photovoltaikmodus (2) zugeordneten Bedeckungssensor (11) aufweisen.

13. Photovoltaikanlage gemäß einem der Ansprüche 10 bis 12, bei der die Mittel zum Heizen und/oder Kühlen und/oder zum Abtauen der Photovoltaikmodule (2) ein Luftklimagerät (15) umfassen.

14. Photovoltaikanlage gemäß Anspruch 13, bei der die Mittel zum Heizen und/oder Kühlen und/oder Abtauen (15) der Photovoltaikmodule (2) Luftkammern (14) an der Unterseite der Photovoltaikmodule (2) umfassen, an die das Luftklimagerät (15) angeschlossen ist.

15. Photovoltaikanlage nach einem der Ansprüche 7 bis 14, bei der die Steuerungsvorrichtung (3) so beschaffen ist, dass sie die erfassten elektrischen Leistungen der Photovoltaikmodule (2) mit einer unteren und/oder oberen Leistungsgrenze vergleicht und Photovoltaikmodule (2), die die untere Leistungsgrenze unterschreiten, oder die obere Leistungsgrenze überschreiten, nicht in ein Gleichspannungsnetz (6.1, 6.2, 6.3) hineinschaltet.

16. Photovoltaikanlage gemäß einem der Ansprüche 7 bis 15, die mindestens eine zentrale Steuerungsvorrichtung (3) hat, die mit mehreren Photovoltaikmodulen (2) verbunden ist.

17. Photovoltaikanlage gemäß Anspruch 16, bei der die Steuerungsvorrichtung (3) mit den Photovoltaikmodulen (2) über Kabel (9) und/oder über Funk verbunden ist.
